(19) Europäisches Patentamt
European Patent Office
Office européen des brevets

(11) **EP 4 478 239 A1**

(12) **EUROPÄISCHE PATENTANMELDUNG**

(43) Veröffentlichungstag:
**18.12.2024 Patentblatt 2024/51**

(21) Anmeldenummer: **23179661.6**

(22) Anmeldetag: **16.06.2023**

(51) Internationale Patentklassifikation (IPC):
**G06F 30/331** $^{(2020.01)}$   **G06F 30/367** $^{(2020.01)}$

(52) Gemeinsame Patentklassifikation (CPC):
**G06F 30/331; G06F 30/367**

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**KH MA MD TN**

(71) Anmelder: **Siemens Aktiengesellschaft**
**80333 München (DE)**

(72) Erfinder: **Die Erfindernennung liegt noch nicht vor**

(74) Vertreter: **Siemens Patent Attorneys**
**Postfach 22 16 34**
**80506 München (DE)**

(54) **EMULATION EINER ANALOGEN SCHALTUNG MITTELS PROGRAMMIERBARER DIGITALER LOGIK**

(57)  Ein Verfahren (600) zum Emulieren einer vorbestimmten analogen Schaltung (110) mittels einer programmierbaren digitalen Logik umfasst Schritte des Unterteilens der analogen Schaltung (110) in Funktionsblöcke (205, 210); des Zuordnens eines dedizierten Zustandsraums (635) zu jedem Funktionsblock (205, 210); des Bestimmens von mathematischen Beschreibungen von Verhalten der Funktionsblöcke (205, 210) in den jeweiligen Zustandsräumen (635); des Beschreibens von Berechnungseinheiten (218) auf der Basis der mathematischen Beschreibungen, wobei die Berechnungseinheiten (218) die Funktionsblöcke (205, 210) funktional nachbilden; und des Bestimmens von Beschreibungsdaten zur Konfiguration einer programmierbaren digitalen Logik derart, dass es Funktionsblöcke (205, 210) realisiert, die nach Art der analogen Schaltung (110) miteinander verbunden sind.

FIG 1

EP 4 478 239 A1

**Beschreibung**

Die vorliegende Erfindung betrifft die Emulation einer analogen Schaltung. Insbesondere betrifft die Erfindung die Emulation einer komplexen analogen Schaltung in Echtzeit.

Eine analoge Schaltung kann mittels einer digitalen Steuervorrichtung gesteuert werden. Die Steuervorrichtung kann einen Mikrocomputer, einen Mikrocontroller oder eine programmierbare digitale Logik umfassen, beispielsweise in Form eines FPGA. Die Steuervorrichtung kann eine Regelung der analogen Schaltung durchführen, wobei ein analoges Signal der Schaltung mittels eines Analog-Digital-Wandlers an die digitale Steuervorrichtung zurückgeführt werden kann.

Zur Entwicklung der Steuervorrichtung kann die analoge Schaltung durch eine andere Einrichtung emuliert werden, die sich wie die analoge Schaltung verhält. Die Emulation kann mittels konfigurierbarer digitaler Logik erfolgen, die relativ einfach konfiguriert werden kann.

Die analoge Schaltung kann komplex sein und eine große Anzahl aktiver oder passiver elektronischer Bauelemente umfassen. Außerdem kann die analoge Schaltung hohe Anforderungen an eine zeitliche Steuerung stellen.

Bekannte Ansätze zur Emulation einer analogen Schaltung erfordern eine komplexe mathematische Modellierung, deren Berechnungsaufwand mit der zweiten Potenz der Anzahl betrachteter zustandsorientierter Bauelemente ansteigen kann. Es kann schwierig sein, für eine gegebene analoge Schaltung eine korrekte Modellierung zu finden. Selbst wenn eine Modellierung gefunden ist, kann eine Komplexität einer zu deren Ausführung erforderlichen digitalen Logik so groß sein, dass sie praktisch nicht umgesetzt werden kann.

Eine der Erfindung zugrunde liegende Aufgabe besteht daher in der Bereitstellung einer verbesserten Technik zur Emulation einer analogen Schaltung mittels konfigurierbarer digitaler Logik. Die Erfindung löst die Aufgabe mittels der Gegenstände der unabhängigen Ansprüche. Unteransprüche geben bevorzugte Ausführungsformen wieder.

Nach einem ersten Aspekt der vorliegenden Erfindung umfasst ein Verfahren zum Emulieren einer vorbestimmten analogen Schaltung mittels einer programmierbaren digitalen Logik Schritte des Unterteilens der analogen Schaltung in Funktionsblöcke; des Zuordnens eines dedizierten Zustandsraums zu jedem Funktionsblock; des Bestimmens von mathematischen Beschreibungen von Verhalten der Funktionsblöcke in den jeweiligen Zustandsräumen; des Beschreibens von Berechnungseinheiten auf der Basis der mathematischen Beschreibungen, wobei die Berechnungseinheiten die Funktionsblöcke funktional nachbilden; und des Bestimmens von Beschreibungsdaten zur Konfiguration einer programmierbaren digitalen Logik derart, dass es Funktionsblöcke realisiert, die nach Art der analogen Schaltung miteinander verbunden sind.

Durch Ausführen des Verfahrens kann ein schneller und präziser Emulator für die analoge Schaltung bereitgestellt werden. Der Emulator kann durch den Einsatz digitaler Logik mit sehr geringer Verzögerung arbeiten, sodass die Emulation Echtzeit-fähig sein kann. Eine Zeitspanne, innerhalb derer der Emulator sein Verhalten an das Verhalten des analogen Vorbilds anpasst, kann dabei sehr klein sein und im Bereich von Mikrosekunden liegen, in einer bevorzugten Ausführungsform im Bereich von Nanosekunden. Eine Genauigkeit des Emulators im Vergleich zur analogen Schaltung kann im Rahmen der Konfiguration gesteuert werden.

Schritte des Verfahrens können automatisiert ausgeführt werden. Das Verfahren kann, ausgehend von einer Beschreibung einer analogen Schaltung, schrittweise eine Konfiguration generieren, mit der ein konfigurierbarer digitale Logikbaustein konfiguriert werden kann, um praktisch dieselbe Funktion auszuführen. Zwischen Schritten der Umwandlung können jeweils Prüfungen eingefügt werden, um sicherzustellen, dass die jeweilige Umwandlung korrekt und ausreichend genau ist. Die Emulation durch den digitalen Logikbaustein kann als digitaler Zwilling der analogen Schaltung verwendet werden, beispielsweise zur Entwicklung einer Steuerung der analogen Schaltung.

Mittels des Verfahrens kann eine hochwertige Emulation auch einer anspruchsvollen analogen Schaltung gelingen, beispielsweise eine Schaltung, die viele zustandsorientierte Bauelemente umfasst, eine sehr genaue Umsetzung zeitlicher Signalverläufe erfordert oder sehr schnelle Signale verarbeitet. Eine solche analoge Schaltung kann beispielsweise eine Sende- oder Empfangsstufe für elektromagnetische Signale oder einen elektrischen Energiewandler umfassen. Der Energiewandler kann beispielsweise an Bord eines Kraftfahrzeugs, einer Lokomotive, eines Flugzeugs oder bei einer dezentralen Energieversorgung eingesetzt werden. Erfolgt die Steuerung nicht ausreichend genau, so kann eine Effizienz der Energiewandlung beeinträchtigt sein. Schlimmstenfalls können beträchtliche Energien freigesetzt werden und die Schaltung beschädigen oder sogar zerstören.

Das Unterteilen der analogen Schaltung kann manuell erfolgen, es sind aber auch systematische Ansätze bekannt, die automatisch durchgeführt werden können. Beispielsweise können Werkzeuge wie Matlab/-Simulink zur Extraktion verwendet werden. Der Zustandsraum eines Funktionsblocks kann auch mittels eines anderen Werkzeugs bestimmt werden, beispielsweise PLECS.

Eine elektrische Verbindung zwischen zwei Funktionsblöcken kann durch eine stromgesteuerte Stromquelle und eine spannungsgesteuerte Spannungsquelle zwischen zwei korrespondierenden Berechnungseinheiten modelliert werden. Dadurch können die einzelnen Funktionsblöcke separat modelliert und dann miteinander in Kontext gesetzt werden.

Genauer kann eine elektrische Verbindung zwischen einem ersten und einem zweiten Funktionsblock der analogen Schaltung durch eine Stromquelle im ersten Funktionsblock modelliert werden, die auf der Basis eines Stroms im zweiten Funktionsblock gesteuert wird; sowie durch eine Spannungsquelle im zweiten Funktionsblock, die auf der Basis einer Spannung im ersten Funktionsblock gesteuert wird.

Bekannte Ansätze verwenden eine Verarbeitung von Signalen innerhalb einer Berechnungseinheit in Fließkomma-Darstellung. Diese Darstellung ist zwar sehr genau, jedoch aufwändig in der Handhabung. In einer Ausführungsform ist daher bevorzugt, eine Fixkomma-Darstellung zur Repräsentation dieser Signale einzusetzen.

Dazu können Bereichsgrenzen für ein innerhalb einer Berechnungseinheit vorliegendes Signal bestimmt werden. Auf deren Basis kann eine Fixkomma-Darstellung für das Signal bestimmt werden, sodass die Berechnungseinheit das Signal als Fixkomma-Wert bestimmen kann. Die Berechnungseinheit kann dadurch einfacher gestaltet sein und weniger Ressourcen erfordern. Eine Berechnung durch die Berechnungseinheit kann beschleunigt sein.

In einer Ausführungsform werden einander entsprechende Funktionsblöcke der analogen Schaltung bestimmt. Dann kann eine Berechnungseinheit bestimmt werden, die dazu eingerichtet ist, die einander entsprechenden Funktionsblöcke sequenziell zu realisieren.

Dabei kann ausgenutzt werden, dass eine Berechnungseinheit der digitalen Logik eine sehr schnelle Bestimmung durchführen kann, sodass sie im Multiplex-Betrieb nacheinander Bestimmungen für eine Vielzahl Funktionsblöcke durchführen kann. Dies kann insbesondere für eine analoge Schaltung genutzt werden, bei der bestimmte Schaltungsteile in mehrfacher Wiederholung eingesetzt sind.

Beispielsweise kann eine analoge Schaltung, die akustische Daten aus einer Vielzahl Quellen parallel verarbeitet, getrennte Verarbeitungskanäle aufweisen, in denen jeweils dieselben analogen Komponenten liegen. Derartige Komponenten können etwa einen frequenzabhängigen Filter, einen automatisch gesteuerten Verstärker, einen Modulator oder einen Demodulator umfassen.

Die Schaltung kann derart unterteilt werden, dass eine Grenze zwischen zwei Funktionsblöcken durch einen Knoten verläuft, der im Betrieb der Schaltung ein Signal mit möglichst wenigen spektralen Frequenzkomponenten trägt. Diese Bedingung kann einem automatischen Segmentierer als Zielfunktion übergeben werden, sodass gebildete Funktionsblöcke bezüglich der Emulation gut handhabbar sein können. Insbesondere kann eine mathematische Beschreibung eines Verhaltens eines Funktionsblocks in seinem Zustandsraum verbessert handhabbar sein.

Die analoge Schaltung kann digital steuerbar sein und ein digitaler Steuereingang der Schaltung kann durch einen digitalen Steuereingang der konfigurierbaren digitalen Logik nachgebildet werden. Die Emulation kann insbesondere eingesetzt werden, um eine digitale Steuerung der analogen Schaltung zu entwickeln oder zu testen. ⌐L⌐ SEP⌐

Die konfigurierbare digitale Logik kann einen Analog-Digital-Wandler (Analog Digital Converter, ADC) zur digitalen Bereitstellung eines analogen Werts der analogen Schaltung emulieren. In einer Ausführungsform ist ein ADC von der konfigurierbaren Logik als Baustein umfasst, dessen elektrische Verbindung zu anderen Elementen konfiguriert werden kann. Ein durch den ADC bereitgestellter digitaler Wert kann von einer digitalen Steuerung nach Art einer Rückkopplung ausgewertet werden, insbesondere um eine Regelung der analogen Schaltung durchzuführen.

Die Beschreibungsdaten werden in einer weiteren Ausführungsform in Konfigurationsdaten zur Konfiguration einer vorbestimmten programmierbaren digitalen Logik umgesetzt, um die analoge Schaltung mittels der programmierbaren digitalen Logik zu emulieren. Dabei kann eine konkrete programmierbare Logik angegeben werden, auf die die bereitgestellten Konfigurationsdaten angewendet werden können. ⌐L⌐ SEP⌐ In einer Ausführungsform umfasst das Verfahren das Konfigurieren der programmierbaren digitalen Logik auf der Basis der Konfigurationsdaten. Die Logik kann dadurch zu einem Emulator konfiguriert werden, der die analoge Schaltung nachahmen kann.

Nach einem weiteren Aspekt der vorliegenden Erfindung umfasst eine Vorrichtung zur Emulation einer vorbestimmten analogen Schaltung mittels einer programmierbaren digitalen Logik: eine erste Einrichtung zur Unterteilung der analogen Schaltung in Funktionsblöcke, wobei jedem Funktionsblock ein dedizierter Zustandsraum zugeordnet ist; eine zweite Einrichtung zur Bestimmung von mathematischen Beschreibungen von Verhalten der Funktionsblöcke in den jeweiligen Zustandsräumen; eine dritte Einrichtung zur Beschreibung von Berechnungseinheiten auf der Basis der mathematischen Beschreibungen, wobei die Berechnungseinheiten die Funktionsblöcke funktional nachbilden; und eine vierte Einrichtung zur Bestimmung von Beschreibungsdaten zur Konfiguration einer programmierbaren digitalen Logik derart, dass sie Funktionsblöcke realisiert, die nach Art der analogen Schaltung miteinander verbunden sind.

Nach wieder einem weiteren Aspekt der vorliegenden Erfindung sind Beschreibungsdaten zur Beschreibung einer programmierbaren digitalen Logik zur Emulation einer vorbestimmten analogen Schaltung mittels eines hierin beschriebenen Verfahrens erstellt. In entsprechender Weise können Konfigurationsdaten zur Konfiguration einer programmierbaren digitalen Logik zur Emulation einer vorbestimmten analogen Schaltung mittels eines hierin beschriebenen Verfahrens erstellt sein. Die Beschreibungs- oder Konfigurationsdaten können auf einem computerlesbaren Datenträger abgespeichert sein.

Nach wieder einem weiteren Aspekt der vorliegenden Erfindung umfasst eine Anwendungsspezifische integrierte Schaltung (application specific integrated circuit, ASIC) eine digitale Logik, die auf der Basis hierin beschriebener Konfigurationsdaten konfiguriert ist. Dazu können die Konfigurationsdaten mittels eines hierin beschriebenen Verfahrens erstellt sein. In einer anderen Ausführungsform kann eine digitale Logik eingesetzt werden, die nur einmal programmierbar ist, beispielsweise als OTP-Logik (one time programmable).

Nach abermals einem weiteren Aspekt der vorliegenden Erfindung ist eine programmierbare digitale Logik mittels eines hierin beschriebenen Verfahrens zur Emulation einer vorbestimmten analogen Schaltung konfiguriert.

Eine hierin genannte programmierbare digitale Logik kann insbesondere durch ein FPGA (Field Programmable Gate Array) realisiert sein. Das FPGA kann mittels Konfigurationsdaten dazu konfiguriert werden, eine vorbestimmte logische Schaltung zu bilden. Anders als bei der Programmierung von Computern, Mikrocontrollern oder Steuerungen kann das Konfigurieren die Definition einer gewünschten Schaltungsstruktur umfassen. Diese kann mittels einer Hardware Beschreibungssprache formuliert und von einer Erzeugersoftware in eine Konfigurationsdatei übersetzt werden, welche vorgibt, wie physische Elemente, die vom FPGA umfasst sind, elektrisch verschaltet werden sollen. Ohne Konfiguration hat ein FPGA üblicherweise keine nutzbare Funktion.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei

Figur 1     ein Steuersystem;
Figur 2     eine schematische Modellierung einer analogen Schaltung;
Figur 3     eine schematische Modellierung einer analogen Schaltung mit mehreren identischen Funktionsblöcken;
Figur 4     eine Modellierung eines linearen zeitinvarianten Systems;
Figur 5     eine Modellierung mehrerer identischer linearer zeitinvarianter Systeme; und
Figur 6     ein Ablaufdiagramm eines Verfahrens

darstellt.

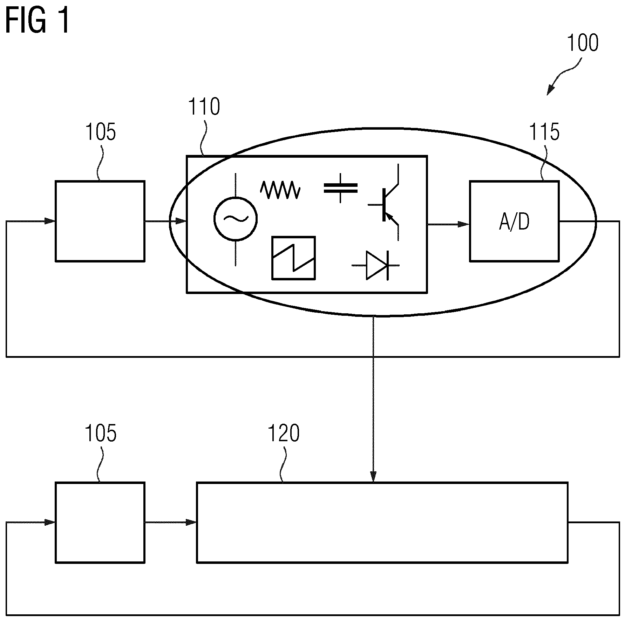

Figur 1 zeigt ein Steuersystem 100, das eine digitale Steuervorrichtung 105 umfasst, die eine analoge Schaltung 110 steuert. Dazu kann die Steuervorrichtung 105 einen digitalen Steuerwert an die analoge Schaltung 110 bereitstellen.

Ein digitaler Steuerwert kann auch mittels eines Digital-Analog-Wandlers (Digital Analog Converter, DAC) in einen analogen Wert umgesetzt werden, der dann zur Steuerung der analogen Schaltung 110 verwendet werden kann. Die Steuervorrichtung 105 ist bevorzugt elektronisch aufgebaut und kann beispielsweise einen programmierbaren Mikrocomputer, einen Mikrocontroller, eine diskrete digitale Schaltung oder einen konfigurierbaren Logikbaustein, etwa in Form eines FPGA umfassen.

Die analoge Schaltung 110 kann eine beliebige Verschaltung aktiver und/oder passiver elektronischer Komponenten umfassen. Die Komponenten können insbesondere Widerstände, Kondensatoren, Spulen oder Halbleiter wie Dioden, Z-Dioden oder Transistoren umfassen. Die analoge Schaltung 110 dient einem vorbestimmten Zweck, beispielsweise der Umwandlung einer Gleichspannung in eine Wechselspannung oder dem Aussenden oder Empfangen elektromagnetischer Strahlung.

Die analoge Schaltung 110 kann einen analogen Wert bereitstellen, der mittels eines ADC in einen digitalen Wert gewandelt und von der Steuervorrichtung 105 zur Steuerung der analogen Schaltung 110 herangezogen werden kann. Dadurch kann eine Regelung der analogen Schaltung 110 bezüglich eines vorbestimmten Regelungsziels realisiert sein.

Beispielsweise zum Zweck der Entwicklung oder dem Testen der Steuervorrichtung 105 soll die analoge Schaltung 110 durch einen Emulator 120 ersetzt werden. Bevorzugt umfasst der Emulator 120 auch den ADC 115. Der Emulator 120 soll insbesondere auf der Basis konfigurierbarer Logik erstellt werden. Dazu können einer oder mehrere miteinander verbundene Logikbausteine vorgesehen sein, die mittels Konfigurationsdaten zu einer Anordnung von Berechnungseinheiten gestaltet werden können. Dabei sind die Berechnungseinheiten derart gestaltet und miteinander verbunden, dass sich der Emulator 120 gegenüber der Steuervorrichtung 105 wie die analoge Schaltung 110 verhält.

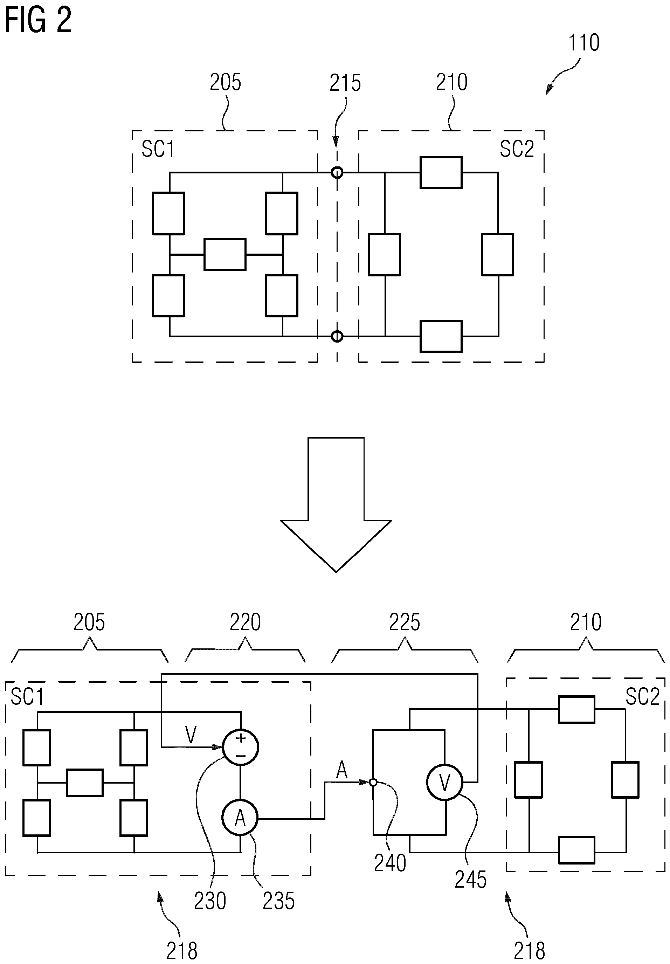

Figur 2 zeigt eine schematische Modellierung einer beispielhaften analogen Schaltung 110. Die analoge Schaltung 110 kann in miteinander verbundene Funktionsblöcke unterteilt werden. In Figur 2 sind ein erster Funktionsblock 205 und ein zweiter Funktionsblock 210 gebildet, die jeweils beispielhaft mehrere elektrische oder elektronische Bauelemente der Schaltung 110 umfassen. Verbindungen zwischen den Funktionsblöcken 205 verlaufen durch Knoten 215.

Wie im unteren Bereich von Figur 2 dargestellt ist, können die Funktionsblöcke 205 und 210 voneinander unabhängig mittels einer ersten und einer zweiten Berechnungseinheit 218 modelliert werden. Die Verbindung zwischen den Funktionsblöcken kann durch eine erste virtuelle Schaltung 220 am ersten Funktionsblock 205 und eine zweite virtuelle Schaltung 225 am zweiten Funktionsblock 210 modelliert werden. Die erste virtuelle Schaltung 220 umfasst eine Spannungsquelle 230, die in Serie mit einem Strommesser 235 an Anschlüssen des ersten Funktionsblocks 205 zu den Knoten 215 liegt. Die zweite virtuelle Schaltung 225 umfasst eine Stromquelle 240, die parallel zu einem Spannungsmesser 245 an Anschlüssen des zweiten Funktionsblocks 210 zu den Knoten 215 liegt. Dabei wird die Stromquelle 240 auf der Basis eines mittels des Strommessers 235 bestimmten Stroms gesteuert; und die Spannungsquelle 230 wird auf der Basis einer mittels des Spannungsmessers 245 bestimmten Spannung gesteuert.

Die im unteren Bereich von Figur 2 gezeigte Schaltung kann verwendet werden, um die Funktionsblöcke 205, 210 der analogen Schaltung 110 zu modellieren, mathematisch zu beschreiben und eine geeignete digitale Logik zu bestimmen, die sie jeweils repräsentiert. Auf dieser Basis kann für jeden Funktionsblock 205, 210 eine Berechnungseinheit 218 aus Elementen einer konfigurierbaren digitalen Logik bestimmt werden, die den jeweiligen Funktionsblock 205, 210 emuliert.

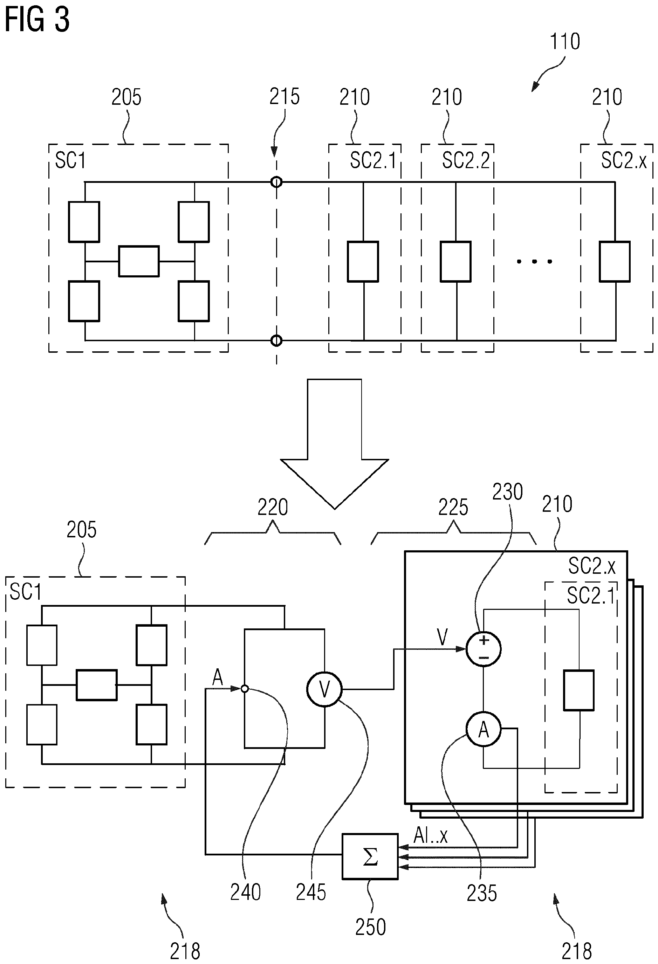

Figur 3 zeigt eine schematische Modellierung einer analogen Schaltung 110 mit mehreren identischen oder sehr ähnlichen zweiten Funktionsblöcken 210. Anstatt die zweiten Funktionsblöcke 210 eins zu eins durch Berechnungseinheiten 218 zu emulieren, können sie als ein Funktionsblock 210 modelliert werden, der nacheinander verschiedene Funktionen ausführt. Dazu kann ein Zustandsspeicher eingefügt werden, der einen Zustand eines zweiten Funktionsblocks 210 speichert, bis dieser zweite Funktionsblock auf der Berechnungseinheit 218 ausgeführt wird. Ein Akkumulator 250 kann eine Summe über sämtliche Ströme zur Rückkopplung an die erste virtuelle Schaltung 220 bilden. Die Berechnungseinheit 218 kann die zweiten Funktionsblöcke 210 nacheinander emulieren und jeweilige Ein- und Ausgabewerte mit angeschlossenen weiteren Funktionsblöcken bzw. Berechnungseinheiten 218 austauschen.

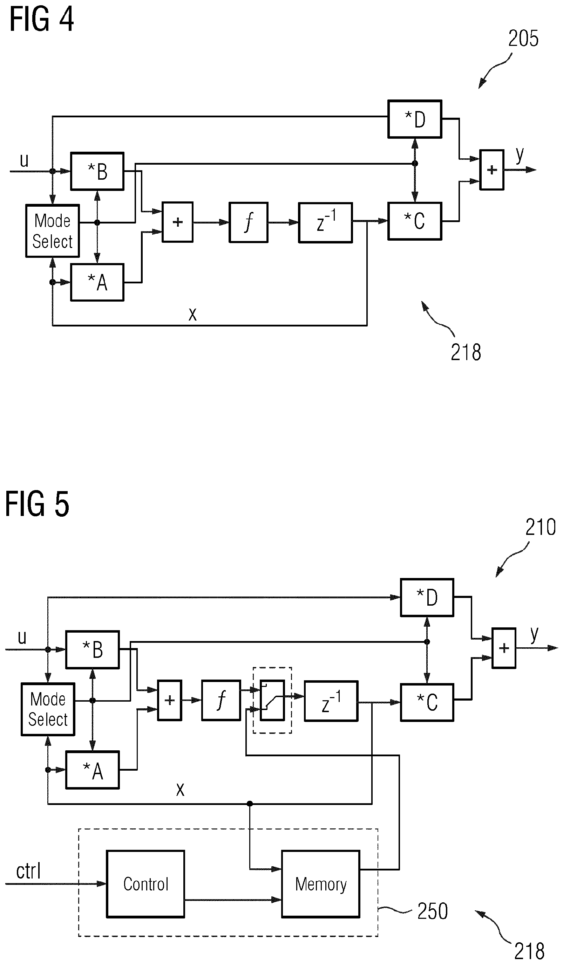

Figur 4 zeigt eine Modellierung einer Funktionskomponente 205 als lineares zeitinvariantes System. Die Funktionskomponente 205 erhält allgemein ein Eingangssignal u und stellt ein Ausgangssignal y bereit. Dabei bestehen folgende Zusammenhänge:

$$\dot{x} = Ax + Xu$$

$$y = Cx + Du$$

Die Funktionskomponente 205 kann als lineares zeitinvariantes System LZI (linear time invariant system, LTI) in einem zugeordneten Zustandsraum modelliert sein.

Auch eine komplexe analoge Schaltung 110 kann als Verschaltung von LZI modelliert werden. Zur Emulation der analogen Schaltung 110 kann jede Funktionskomponente 205 als LZI durch passende digitale Logik implementiert werden. Zur Emulation einer Funktionskomponente 205 sind geeignete Matrizen A, B, C und D für die korrespondierende LZI-Darstellung zu finden.

Zur Umsetzung der Funktionskomponente 205 als Konfiguration digitaler Logik ist es vorteilhaft, die Berechnung des Ausgangssignals y auf der Basis des Eingangssignals u mit Werten in Fixkomma-Darstellung statt in Fließkomma-Darstellung zu bestimmen. Dazu können im Betrieb der Funktionskomponente 205 jeweils Bereichsgrenzen für das Eingangssignal u und Ausgänge der Matrizen A bis D bestimmt werden. In Kenntnis der Bereichsgrenzen kann dann eine Fließkomma-Darstellung durch eine Fixkomma-Darstellung abgelöst werden. Die Fixkomma-Darstellung kann eine wesentlich schnellere Berechnung beispielsweise von Matrizenoperationen erlauben. Figur 5 zeigt eine Modellierung mehrerer identischer linearer zeitinvarianter Systeme nach Art von Figur 3. Die LZI-Modellierung einer Funktionskomponente 210 wird um einen den Zustandsspeicher 250 erweitert, der einen Speicher umfasst, in dem Zustandswerte für eine vorbestimmte Anzahl zu emulierender Funktionskomponenten 210 aufgenommen werden können. Ein Zustand einer zu emulierenden Funktionskomponente 210 kann aus dem Speicher abgerufen und in die LZI-Darstellung eingespeist werden. So kann eine Berechnungseinheit 218 bestimmt werden, die sequenziell mehrere Funktionskomponenten 210 emulieren kann. Für angrenzende Berechnungseinheiten 218 kann die sequenzielle Emulation nicht erkennbar sein, sodass sich die mehrfach genutzte Berechnungseinheit 218 im Emulator 120 für die analoge Schaltung 110 wie eine Anzahl einzelner Berechnungseinheiten 218 verhalten kann.

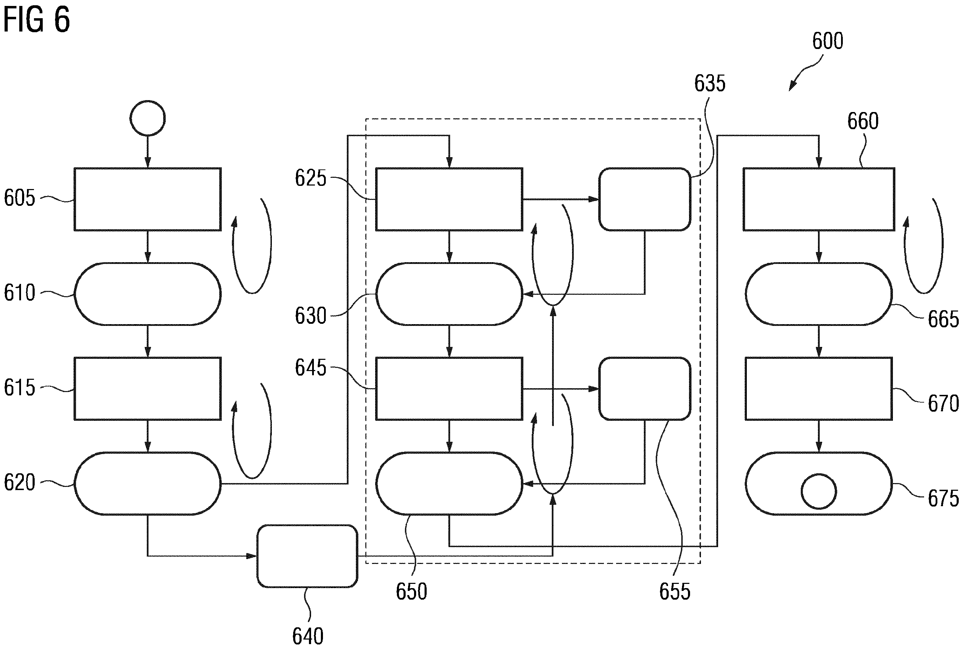

Figur 6 zeigt ein Ablaufdiagramm eines beispielhaften Verfahrens 600 zum Bereitstellen eines Emulators 120 zur Emulation einer vorbestimmten analogen Schaltung 110. Das Verfahren 600 kann iterativ durchlaufen werden, um einen mittels konfigurierbarer digitaler Logik implementierten Emulator 120 bereitzustellen, der sich bezüglich Eingangs- und Ausgangssignalen wie die analoge Schaltung 110 verhält.

In einem Schritt 605 kann die analoge Schaltung 110 erstellt oder verändert werden. Dabei liegt die Schaltung 110 in einer per Computer verarbeitbaren Beschreibung 610 vor, beispielsweise als Simscape Datei der Software Simulink des Herstellers The MathWorks. Wird eine andere Software verwendet, beispielsweise PLECS, so kann die Beschreibung 610 entsprechend in einem anderen digitalen Format vorliegen.

Optional kann eine Verifikation der Äquivalenz der Beschreibung 610 mit der Schaltung 110 erfolgen. Außerdem kann eine Stabilität des erstellten Systems geprüft werden.

In einem Schritt 615 kann die analoge Schaltung 110 in Funktionsblöcke 205, 210 unterteilt werden. Dieser Schritt kann manuell, teilautomatisiert oder automatisiert durchgeführt werden. Als Resultat kann eine segmentierte Beschreibung 620 erstellt werden. Ein Format der Beschreibung 620 kann von einer zur Segmentierung eingesetzten Software abhängig sein. Optional kann eine Verifikation der Äquivalenz der segmentierten Beschreibung 620 mit der einteiligen Beschreibung 610 erfolgen. Auch an dieser Stelle kann das erstellte System auf Stabilität getestet werden.

In einem Schritt 625 kann teilautomatisiert oder automatisch ein Modell eines digitalen Rechenwerks bestimmt werden, um eine digitalisierte, in Logikbausteinen ausführbare Funktionseinheit zu erstellen. Die modellierten Funktionsblöcke 205, 210 sind dabei zunächst in Fließkomma-Darstellung 630 angegeben. Dabei kann jedem Funktionsblock 205, 210 ein Zustandsraum 635 zugeordnet werden. Die Äquivalenz der erstellten Darstellung 630 mit der segmentierten Beschreibung 620 kann in einem entsprechenden Test verifiziert werden.

Auf der Basis der segmentierten Beschreibung 620 können Signale 640 der Funktionsblöcke 205, 210 verfolgt werden (tracing). In einem Schritt 645 kann eine Fixkomma-Umwandlung auf der Basis der Fließkomma-Darstellung 630 und der Signale 640 erfolgen. Dazu können zunächst Bereichsgrenzen der Signale 640 bestimmt werden. Resultat der Umwandlung ist eine Fixkomma-Darstellung 650 der Signale 640. Im Rahmen der Umwandlung können Datentypen 655 für den Zustandsraum bestimmt werden.

Die Äquivalenz der Fixkomma-Darstellung 650 mit der Fließkomma-Darstellung 630 kann verifiziert werden. Außerdem kann bestimmt werden, ob die durchgeführte Umwandlung der Fließkomma-Darstellung 650 in die Fließkomma-Darstellung 630 ausreichend genau ist.

In einem Schritt 660 können mehrere zweite Funktionskomponenten 210 serialisiert werden. Dazu werden identische oder ausreichend ähnliche zweite Funktionskomponenten 210 identifiziert und durch eine einzige Funktionskomponente 210 mit einem Zustandsspeicher 250 und einer Steuerung zur sequenziellen Emulation der einzelnen Funktionskomponenten 210 ersetzt. Als Resultat dieses Schritts kann ein vollständig digitalisiertes System 665 erstellt werden, das eine Beschreibung einer digitalen Logik umfasst, die zur Emulation der analogen Schaltung 110 eingesetzt werden kann. Auch hier erfolgt optional eine Verifikation der Korrektheit der durchgeführten Umsetzung.

In einem Schritt 670 kann aus der Beschreibung des Systems 665 HDL-Code 675 (HDL: Hardware Description Language) erzeugt werden, der zur Konfiguration eines konkreten Bauelements mit konfigurierbarer digitaler Logik eingesetzt werden kann.

Obwohl die Erfindung im Detail durch Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Unabhängig vom grammatikalischen Geschlecht eines hierin verwendeten bestimmten Begriffs sind Personen mit männlicher, weiblicher oder anderer Geschlechteridentität mit umfasst.

## Patentansprüche

1. Verfahren (600) zum Emulieren einer vorbestimmten analogen Schaltung (110) mittels konfigurierbarer digitaler Logik, wobei das Verfahren (600) folgende Schritte umfasst:

    - Unterteilen (615) der analogen Schaltung (110) in Funktionsblöcke (205, 210);
    - Zuordnen (625) eines dedizierten Zustandsraums (635) zu jedem Funktionsblock (205, 210);
    - Bestimmen (625) von mathematischen Beschreibungen von Verhalten der Funktionsblöcke (205, 210) in den jeweiligen Zustandsräumen (635);
    - Beschreiben (625) von Berechnungseinheiten (218) auf der Basis der mathematischen Beschreibungen, wobei die Berechnungseinheiten (218) die Funktionsblöcke (205, 210) funktional nachbilden; und
    - Bestimmen (660) von Beschreibungsdaten zur Konfiguration eines konfigurierbaren digitalen Logikbausteins derart, dass es Funktionsblöcke (205, 210) realisiert, die nach Art der analogen Schaltung (110) miteinander verbunden sind.

2. Verfahren (600) nach Anspruch 1, wobei eine elektrische Verbindung zwischen zwei Funktionsblöcken (205, 210) durch eine stromgesteuerte Stromquelle (240) und eine spannungsgesteuerte Spannungsquelle (230) zwischen zwei korrespondierenden Berechnungseinheiten (218) modelliert wird.

3. Verfahren (600) nach Anspruch 2, wobei eine elektrische Verbindung zwischen einem ersten und einem zweiten Funktionsblock (205, 210) der analogen Schaltung (110) durch eine Stromquelle (240) im ersten Funktionsblock (205), die auf der Basis eines Stroms im zweiten Funktionsblock (210) gesteuert wird, modelliert wird; sowie durch eine Spannungsquelle (230) im zweiten Funktionsblock (210), die auf der Basis einer Spannung im ersten Funktionsblock (205) gesteuert wird.

4. Verfahren (600) nach einem der vorangehenden Ansprüche, wobei Bereichsgrenzen für ein innerhalb einer Berechnungseinheit (218) vorliegendes Signal bestimmt (645) werden; wobei eine Fixkomma-Darstellung für das Signal bestimmt wird; und wobei die Berechnungseinheit (218) das Signal als Fixkomma-Wert bestimmt.

5. Verfahren (600) nach einem der vorangehenden Ansprüche, wobei einander entsprechende Funktionsblöcke (210) der analogen Schaltung (110) bestimmt werden; wobei eine Berechnungseinheit (218) bestimmt (660) wird, die dazu eingerichtet ist, die einander entsprechenden Funktionsblöcke (210) sequenziell zu realisieren.

6. Verfahren (600) nach einem der vorangehenden Ansprüche, wobei die Schaltung (110) derart unterteilt wird, dass eine Grenze zwischen zwei Funktionsblöcken (205, 210) durch einen Knoten (215) verläuft, der im Betrieb der Schaltung (110) ein Signal mit möglichst wenigen spektralen Frequenzkomponenten trägt.

7. Verfahren (600) nach einem der vorangehenden Ansprüche, wobei die analoge Schaltung (110) digital steuerbar ist und ein digitaler Steuereingang der Schaltung (110) durch einen digitalen Steuereingang der konfigurierbaren digitalen Logik nachgebildet wird.

8. Verfahren (600) nach einem der vorangehenden Ansprüche, wobei die konfigurierbare digitale Logik zusätzlich einen Analog-Digital-Wandler zur digitalen Bereitstellung eines analogen Werts der analogen Schaltung (110) emuliert.

9. Verfahren (600) nach einem der vorangehenden Ansprüche, wobei die Beschreibungsdaten in Konfigurationsdaten zur Konfiguration einer vorbestimmten programmierbaren digitalen Logik umgesetzt (670) werden, um die analoge Schaltung (110) mittels der programmierbaren digitalen Logik zu emulieren.

10. Verfahren (600) nach Anspruch 9, wobei die programmierbare digitale Logik auf der Basis der Konfigurationsdaten konfiguriert wird.

11. Vorrichtung zur Emulation einer vorbestimmten analogen Schaltung (110) mittels einer programmierbaren digitalen Logik, wobei die Vorrichtung folgendes umfasst:

  - eine erste Einrichtung zur Unterteilung der analogen Schaltung (110) in Funktionsblöcke (205, 210), wobei jedem Funktionsblock (205, 210) ein dedizierter Zustandsraum (635) zugeordnet ist;
  - eine zweite Einrichtung zur Bestimmung von mathematischen Beschreibungen von Verhalten der Funktionsblöcke (205, 210) in den jeweiligen Zustandsräumen (635);
  - eine dritte Einrichtung zur Beschreibung von Berechnungseinheiten (218) auf der Basis der mathematischen Beschreibungen, wobei die Berechnungseinheiten (218) die Funktionsblöcke (205, 210) funktional nachbilden; und
  - eine vierte Einrichtung zur Bestimmung von Beschreibungsdaten zur Konfiguration einer programmierbaren digitalen Logik derart, dass sie Funktionsblöcke (205, 210) realisiert, die nach Art der analogen Schaltung (110) miteinander verbunden sind.

12. Konfigurationsdaten zur Konfiguration einer programmierbaren digitalen Logik zur Emulation einer vorbestimmten analogen Schaltung (110), wobei die Konfigurationsdaten mittels eines Verfahrens (600) nach Anspruch 9 erstellt sind.

13. Anwendungsspezifische integrierte Schaltung, umfassend eine digitale Logik, die auf der Basis von Konfigurationsdaten nach Anspruch 12 konfiguriert ist.

14. Programmierbare digitale Logik, die mittels eines Verfahrens (600) nach Anspruch 10 zur Emulation einer vorbestimmten analogen Schaltung (110) konfiguriert ist.

15. FPGA, umfassend eine programmierbare digitale Logik nach Anspruch 14.

FIG 1

# FIG 2

## FIG 3

## FIG 4

205

218

## FIG 5

210

250

218

# FIG 6

EP 4 478 239 A1

**EUROPÄISCHER RECHERCHENBERICHT**

Europäisches Patentamt
European Patent Office
Office européen des brevets

Nummer der Anmeldung

EP 23 17 9661

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | STANLEY DANIEL ET AL: "Fast Validation of Mixed-Signal SoCs", IEEE OPEN JOURNAL OF THE SOLID-STATE CIRCUITS SOCIETY, IEEE, Bd. 1, 25. Oktober 2021 (2021-10-25), Seiten 184-195, XP011887017, DOI: 10.1109/OJSSCS.2021.3122397 [gefunden am 2021-11-05] * Zusammenfassung * * Seite 184 – Seite 193 * * Abbildungen 2, 4 * ----- | 1-15 | INV. G06F30/331 G06F30/367 |
| X | WU WEI ET AL: "Wave digital filter based analog circuit emulation on FPGA", 2016 IEEE INTERNATIONAL SYMPOSIUM ON CIRCUITS AND SYSTEMS (ISCAS), IEEE, 22. Mai 2016 (2016-05-22), Seiten 1286-1289, XP032941792, DOI: 10.1109/ISCAS.2016.7527483 [gefunden am 2016-07-29] * Zusammenfassung * * Seite 1286 – Seite 1289 * ----- | 1-15 | |
| X | TERTEL PHILIPP ET AL: "Real-time emulation of block-based analog circuits on an FPGA", INTEGRATION, THE VLSI JOURNAL, NORTH-HOLLAND PUBLISHING COMPANY. AMSTERDAM, NL, Bd. 63, 5. April 2018 (2018-04-05), Seiten 373-382, XP085492191, ISSN: 0167-9260, DOI: 10.1016/J.VLSI.2018.01.008 * Zusammenfassung * * Seite 373 – Seite 379 * ----- -/-- | 1-15 | RECHERCHIERTE SACHGEBIETE (IPC) G06F |

Der vorliegende Recherchenbericht wurde für alle Patentansprüche erstellt

| Recherchenort | Abschlußdatum der Recherche | Prüfer |
|---|---|---|
| München | 5. Dezember 2023 | Radev, Boyan |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

........................................................................
& : Mitglied der gleichen Patentfamilie, übereinstimmendes Dokument

EPO FORM 1503 03.82 (P04C03)

Europäisches Patentamt

European Patent Office

Office européen des brevets

**EUROPÄISCHER RECHERCHENBERICHT**

Nummer der Anmeldung

EP 23 17 9661

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | ALSHAYA ABDULAZIZ ET AL: "Analogue Circuits Real-Time Emulation based on Wave Digital Filter", 2022 IEEE INTERNATIONAL SYMPOSIUM ON CIRCUITS AND SYSTEMS (ISCAS), IEEE, 27. Mai 2022 (2022-05-27), Seiten 1566-1569, XP034224249, DOI: 10.1109/ISCAS48785.2022.9937868 [gefunden am 2022-11-11] * Zusammenfassung * * Seite 1566 – Seite 1568 * ----- | 1-15 | |
| | | | **RECHERCHIERTE SACHGEBIETE (IPC)** |

Der vorliegende Recherchenbericht wurde für alle Patentansprüche erstellt

| Recherchenort | Abschlußdatum der Recherche | Prüfer |
|---|---|---|
| München | 5. Dezember 2023 | Radev, Boyan |

EPO FORM 1503 03.82 (P04C03)